# EUROPEAN PATENT APPLICATION

(11) **EP 3 882 966 A1**
(43) Date of publication of application: **22.09.2021**
(21) Application number: 18944875.6
(22) Date of filing: 29.12.2018
(51) Int. Cl.: H01L 23/522, H01L 23/58, H01L 29/76

(54) **SIGNAL ISOLATION APPARATUS AND SIGNAL ISOLATION METHOD**

(71) Applicant: Huawei Technologies Co., Ltd., Shenzhen Guangdong 518129 (CN)
(72) Inventor: ZHU, Qianming, Shenzhen, Guangdong 518129 (CN); YE, Wenhui, Shenzhen, Guangdong 518129 (CN)
(74) Representative: Maiwald Patent- und Rechtsanwaltsgesellschaft mbH
(86) International application number: PCT/CN2018/125858
(87) International publication number: WO 2020/133530

(57) **Abstract**

This application relates to the field of semiconductor devices, and discloses a signal isolation apparatus. The signal isolation apparatus includes: a metal oxide semiconductor (MOS) device, where the MOS device is formed on a P-type substrate and has an N well; an N-type substrate contact, where the N-type substrate contact is formed in the N well and connected to supply voltage; a P-type substrate contact, where the P-type substrate contact is formed on the P-type substrate and connected to grounding voltage; and an isolation ring at least partially surrounding the N well, where a doping density of an ion implanted into the isolation ring is lower than a doping density of an ion implanted into the N well or a doping density of an ion implanted into the P-type substrate. The N well is surrounded by the isolation ring, and a density of the isolation ring is lower than a density of the N well or a density of the P-type substrate. Therefore, a junction capacitance of a P-N junction formed between the N well and the P-type substrate is decreased, and an equivalent capacitive reactance of the P-N junction when a noise signal passes through the P-N junction is increased, thereby improving an effect of isolating the noise signal.

## Description

### TECHNICAL FIELD

This application relates to semiconductor device technologies, and in particular, to a signal isolation apparatus and a signal isolation method.

### BACKGROUND

Currently, a mainstream process of chip manufacturing is a complementary metal oxide semiconductor (Complementary Metal Oxide Semiconductor, CMOS) process, and a large quantity of integrated circuits (Integrated circuit, IC) are implemented by using a CMOS process technology based on a wafer substrate.

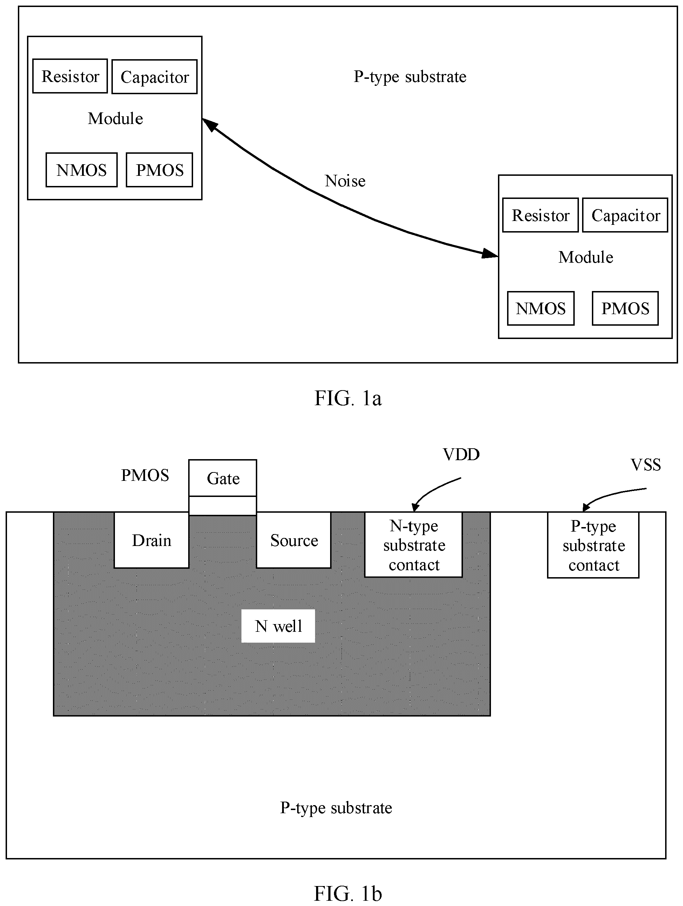

FIG. 1a is a schematic diagram of noise signal transmission between two modules formed on a P-type substrate. The two modules each include devices such as a resistor, a capacitor, a P channel metal oxide semiconductor (P Channel Metal Oxide Semiconductor, PMOS), and an N channel metal oxide semiconductor (N channel metal oxide semiconductor, NMOS). These devices are all formed in a well of the P-type substrate. Although the P-type substrate has a relatively high resistance, high-frequency noise signals generated by these devices may still interfere with each other between different devices by using the P-type substrate to form substrate noise. For example, in FIG. 1a, noise generated by a device in one module interferes with a device in the other module.

It should be noted that FIG. 1a is a top view. In addition to the resistor, the capacitor, the PMOS, and the NMOS, the two modules each may further include another device. Certainly, the two modules each may include only one or more of the devices such as the resistor, the capacitor, the PMOS, and the NMOS. A device included in the module is not limited in this application.

To resolve the substrate noise problem, some signal isolation structures are provided in the prior art. For example, FIG. 1b is a noise signal isolation apparatus based on a PMOS. The PMOS device is formed on a P-type substrate and has an N well (Nwell). An N-type substrate contact is formed in the N well and connected to supply voltage (VDD), and a P-type substrate contact is formed on the P-type substrate and connected to grounding voltage (VSS). The PMOS device includes a source (Source), a drain (Drain), and a gate (Gate).

When a circuit works normally, the N-type substrate contact in the N well is connected to a high potential of the supply voltage, and the P-type substrate contact on the P-type substrate is connected to a low potential of the grounding voltage. Because the N well is in an N type and the P-type substrate is in a P type, a P-N junction is formed between the N well and the P-type substrate. In addition, because the P-type substrate is grounded, the P-N junction is reverse biased. The reverse biased P-N junction has a blocking effect, and therefore the reverse biased P-N junction formed between the N well and the P-type substrate may isolate a noise signal.

A junction capacitance of a P-N junction is inversely proportional to an equivalent capacitive reactance of the P-N junction when a noise signal passes through the P-N junction, and a junction capacitance of the reverse biased P-N junction formed between the N well and the P-type substrate is relatively large. As a result, an equivalent capacitive reactance of the reverse biased P-N junction when a noise signal passes through the reverse biased P-N junction is relatively small, and an effect of isolating the noise signal is relatively poor.

### SUMMARY

Embodiments of this application provide a signal isolation apparatus and a signal isolation method, to improve an effect of isolating a noise signal.

To achieve the foregoing objective, the embodiments of this application provide the following technical solutions.

According to a first aspect, an embodiment of this application provides a signal isolation apparatus, including:
a metal oxide semiconductor (MOS) device, where the MOS device is formed on a P-type substrate and has an N well;
an N-type substrate contact, where the N-type substrate contact is formed in the N well and connected to supply voltage;
a P-type substrate contact, where the P-type substrate contact is formed on the P-type substrate and connected to grounding voltage; and
an isolation ring at least partially surrounding the N well, where a doping density of an ion implanted into the isolation ring is lower than a doping density of an ion implanted into the N well or a doping density of an ion implanted into the P-type substrate.

The N well is surrounded by the isolation ring, and a density of the isolation ring is lower than a density of the N well or a density of the P-type substrate. Therefore, a junction capacitance of a P-N junction formed between the N well and the P-type substrate is decreased, and an equivalent capacitive reactance of the P-N junction when a noise signal passes through the P-N junction is increased, thereby improving an effect of isolating the noise signal.

In an implementation of the first aspect, the isolation ring is an isolation well, and a doping density of an N-type ion implanted into the isolation well is lower than a doping density of an N-type ion implanted into the N well.

In an implementation of the first aspect, the isolation well may be specifically a high-voltage well.

In an implementation of the first aspect, after the signal isolation apparatus includes the isolation well, the signal isolation apparatus further includes:
an intrinsic substrate at least partially surrounding the isolation well, where a doping density of a P-type ion implanted into the intrinsic substrate is lower than a doping density of a P-type ion implanted into the P-type substrate.

Both the intrinsic substrate and the P-type substrate are implanted with the P-type ion, and the doping density of the P-type ion implanted into the intrinsic substrate is lower than the doping density of the P-type ion implanted into the P-type substrate. Therefore, after the isolation well is surrounded by the intrinsic substrate, the junction capacitance of the P-N junction formed between the N well and the P-type substrate may be further decreased, and the equivalent capacitive reactance of the P-N junction when a noise signal passes through the P-N junction may be further increased, thereby further improving an effect of isolating the noise signal.

In an implementation of the first aspect, the isolation ring may be an intrinsic substrate, and a doping density of a P-type ion implanted into the intrinsic substrate is lower than a doping density of a P-type ion implanted into the P-type substrate.

It may be learned from the effect generated after the isolation well is surrounded by the intrinsic substrate that, a noise signal isolation effect may also be improved by directly surrounding the N well by the intrinsic substrate.

In an implementation of the first aspect, the signal isolation apparatus further includes:
an electrostatic discharge (ESD) implantation layer extending deep into the P-type substrate along the P-type substrate contact, where the ESD implantation layer is a P-type implantation layer.

Because the ESD implantation layer and the P-type substrate contact both are in P-type implantation, the ESD implantation layer may extend the P-type substrate contact. In this way, the ESD implantation layer and the P-type substrate contact can have more contact with a noise signal, and absorb more noise signals to the ground, thereby improving an effect of absorbing a noise signal.

Further, a P-type implantation depth of the ESD implantation layer is greater than a P-type implantation depth of the P-type substrate contact.

In an implementation of the first aspect, the MOS device may be a PMOS or an NMOS.

In an implementation of the first aspect, when the MOS device is an NMOS, a deep N well exists between the NMOS and the P-type substrate. The N well and the deep N well separate the NMOS from the P-type substrate. Existence of the deep N well between the NMOS and the P-type substrate may further improve a noise isolation effect.

According to a second aspect, this application provides a signal isolation method, including:
forming a MOS device on a P-type substrate, where the MOS device has an N well;
forming an N-type substrate contact in the N well, where the N-type substrate contact is connected to supply voltage;
forming a P-type substrate contact on the P-type substrate, where the P-type substrate contact is connected to grounding voltage; and
adding at least a part of an isolation ring around the N well, where a doping density of an ion implanted into the isolation ring is lower than a doping density of an ion implanted into the N well or a doping density of an ion implanted into the P-type substrate.

In an implementation of the second aspect, the isolation ring is an isolation well, and a doping density of an N-type ion implanted into the isolation well is lower than a doping density of an N-type ion implanted into the N well.

In an implementation of the second aspect, the isolation well is a high-voltage well.

In an implementation of the second aspect, the signal isolation method further includes:
adding at least a part of an intrinsic substrate around the isolation well.

In an implementation of the second aspect, the isolation ring is an intrinsic substrate.

In an implementation of the second aspect, the signal isolation method further includes:
adding an ESD implantation layer deep into the P-type substrate along the P-type substrate contact, where the ESD implantation layer is a P-type implantation layer.

Further, a P-type implantation depth of the ESD implantation layer is greater than a P-type implantation depth of the P-type substrate contact.

In an implementation of the second aspect, the MOS device may be a PMOS or an NMOS.

In an implementation of the second aspect, when the MOS device is an NMOS, a deep N well is added between the NMOS and the P-type substrate. The N well and the deep N well separate the NMOS from the P-type substrate.

### BRIEF DESCRIPTION OF DRAWINGS

To describe the technical solutions in the embodiments of this application or in the background more clearly, the following describes the accompanying drawings required for describing the embodiments of this application or the background.
FIG. 1a is a schematic diagram of noise signal transmission between modules formed on a P-type substrate;
FIG. 1b is a schematic diagram of a signal isolation apparatus based on a PMOS;
FIG. 2 is a structural diagram of a signal isolation apparatus based on a PMOS according to an embodiment of this application;
FIG. 3 is a structural diagram of another signal isolation apparatus based on a PMOS according to an embodiment of this application;
FIG. 4 is a structural diagram of a signal isolation apparatus based on an NMOS according to an embodiment of this application;
FIG. 5 is a structural diagram of another signal isolation apparatus based on an NMOS according to an embodiment of this application;
FIG. 6 is a simulation waveform diagram according to an embodiment of this application;
FIG. 7 is a structural diagram of an inter-module signal isolation apparatus according to an embodiment of this application;
FIG. 8 is a structural diagram of another inter-module signal isolation apparatus according to an embodiment of this application;
FIG. 9 is a structural diagram of another inter-module signal isolation apparatus according to an embodiment of this application;
FIG. 10 is a structural diagram of another inter-module signal isolation apparatus according to an embodiment of this application; and
FIG. 11 is a signal isolation method according to an embodiment of this application.

### DESCRIPTION OF EMBODIMENTS

The following describes the technical solutions in the embodiments of this application with reference to the accompanying drawings in the embodiments of this application.

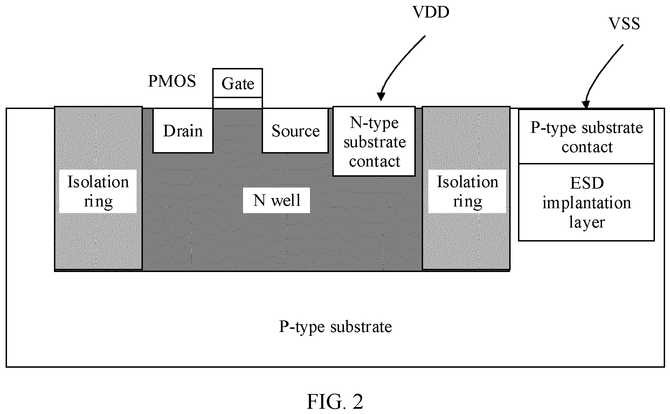

FIG. 2 is a schematic diagram of a signal isolation apparatus based on a PMOS according to this application. The signal isolation apparatus includes a PMOS device, an N-type substrate contact, a P-type substrate contact, and an isolation ring. The PMOS device includes a source (Source), a drain (Drain), and a gate (Gate). The N-type substrate contact is also referred to as Ntap. Ntap is formed by implanting an N-type ion in an oxidation diffusion (Oxide Diffusion, OD) region, and is configured to contact an N well. The P-type substrate contact is also referred to as Ptap. Ptap is formed by implanting a P-type ion in OD, and is configured to contact the P-type substrate contact. The OD is also referred to as an active diffusion region.

Specifically, the PMOS device is formed on a P-type substrate and has an N well (Nwell), the N-type substrate contact is formed in the N well and connected to supply voltage, and the P-type substrate contact is formed on the P-type substrate and connected to grounding voltage. The isolation ring at least partially surrounds the N well, and a density of the isolation ring is lower than a density of the N well or a density of the P-type substrate.

In the signal isolation apparatus, the N well is surrounded by the isolation ring, and the density of the isolation ring is lower than the density of the N well or the density of the P-type substrate. Therefore, a junction capacitance of a P-N junction formed between the N well and the P-type substrate is decreased, and an equivalent capacitive reactance of the P-N junction when a noise signal passes through the P-N junction is increased, thereby improving an effect of isolating the noise signal.

It should be noted that if a capacitance value of the junction capacitance of the P-N junction is c and a frequency of the noise signal is w, an equivalent capacitive reactance of the P-N junction when a noise signal needs to pass through the P-N junction is 1/jwc, where j is an imaginary unit. It may be learned that the capacitance value of the junction capacitance of the P-N junction is inversely proportional to the equivalent capacitive reactance of the P-N junction. To be specific, when the frequency of the noise signal remains unchanged, the equivalent capacitive reactance of the P-N junction may be increased by decreasing the capacitance value of the junction capacitance of the P-N junction.

That the isolation ring at least partially surrounds the N well means that the N well may be partially surround by the isolation ring or that the N well may be all surrounded by the isolation ring (that is, the isolation ring is all around the N well). "Partial surrounding" and "all surrounding" both can implement an isolation effect, and differ in only an isolation degree.

In addition, an N-type ion is implanted into the N well, and that the density of the isolation ring is lower than the density of the N well means that the N-type ion is also implanted into the isolation ring. A P-type ion is implanted into the P-type substrate, and that the density of the isolation ring is lower than the density of the P-type substrate means that the P-type ion is also implanted into the isolation ring.

In an embodiment of this application, the isolation ring is an isolation well (not shown in FIG. 2), and a doping density of an N-type ion implanted into the isolation well is lower than a doping density of an N-type ion implanted into the N well. Different doping densities may be formed by implanting different doses of N-type ions into the isolation well and the N well.

Both the isolation well and the N well are implanted with the N-type ion, and the doping density of the N-type ion implanted into the isolation well is lower than the doping density of the N-type ion implanted into the N well. Therefore, compared with the junction capacitance of the P-N junction formed between the N well and the P-type substrate when the isolation well is not added, a junction capacitance of a P-N junction formed between the P-type substrate and a well obtained by considering the isolation well and the N well as a whole is lower. To be specific, the junction capacitance of the P-N junction formed between the N well and the P-type substrate is decreased, and the equivalent capacitive reactance of the P-N junction when a noise signal passes through the P-N junction is increased, thereby improving an effect of isolating the noise signal.

In an optional embodiment, the isolation well may be a high-voltage well.

In an embodiment of this application, the isolation ring is an intrinsic substrate (not shown in FIG. 2), and a doping density of a P-type ion implanted into the intrinsic substrate is lower than a doping density of a P-type ion implanted into the P-type substrate.

Both the intrinsic substrate and the P-type substrate are implanted with the P-type ion, and the doping density of the P-type ion implanted into the intrinsic substrate is lower than the doping density of the P-type ion implanted into the P-type substrate. Therefore, compared with the junction capacitance of the P-N junction formed between the N well and the P-type substrate when the intrinsic substrate is not added, a junction capacitance of a P-N junction formed between the N well and a P-type substrate obtained by considering the intrinsic substrate and the P-type substrate as a whole is lower. To be specific, the junction capacitance of the P-N junction formed between the N well and the P-type substrate is decreased, and the equivalent capacitive reactance of the P-N junction when a noise signal passes through the P-N junction is increased, thereby improving an effect of isolating the noise signal.

In an embodiment of this application, the signal isolation apparatus further includes an electrostatic discharge (Electro-Static discharge, ESD) implantation (Implant) layer extending deep into the P-type substrate along the P-type substrate contact. The ESD implantation layer is a P-type implantation layer, and is configured to improve an electrostatic discharge capability.

Further, a P-type implantation depth of the ESD implantation layer is greater than a P-type implantation depth of the P-type substrate contact.

Because the ESD implantation layer and the P-type substrate contact both are in P-type implantation, the ESD implantation layer may extend the P-type substrate contact. In this way, the ESD implantation layer and the P-type substrate contact can have more contact with a noise signal, and absorb more noise signals to the ground, thereby improving an effect of absorbing a noise signal.

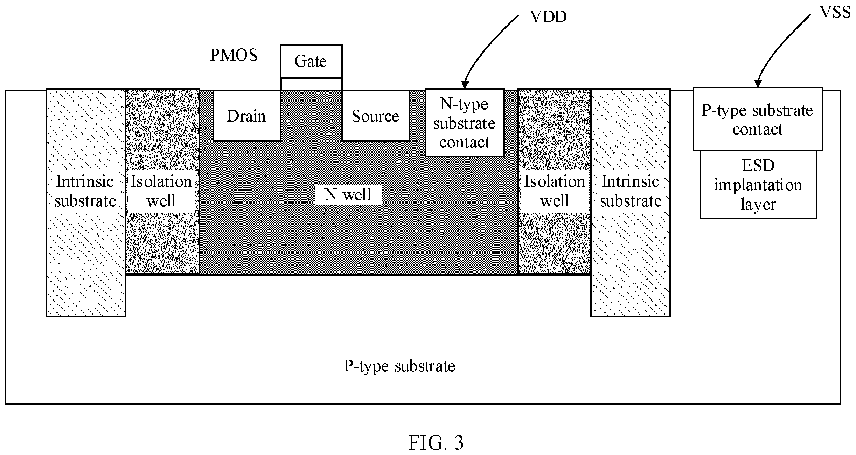

FIG. 3 is a schematic diagram of another signal isolation apparatus based on a PMOS according to this application. A difference between the signal isolation apparatus and the signal isolation apparatus shown in FIG. 2 lies in that the isolation ring is used as the isolation well, and on the basis that the N well is at least partially surrounded by the isolation well, the isolation well is further at least partially surrounded by the intrinsic substrate.

In one aspect, a noise signal isolation effect may be improved by adding the isolation well. In another aspect, because the doping density of the P-type ion implanted into the intrinsic substrate is lower than the doping density of the P-type ion implanted into the P-type substrate, a length of a depletion region between the N well and the P-type substrate is increased, a junction capacitance of a parasitic diode formed between the N well and the P-type substrate is decreased, and an equivalent capacitive reactance of the parasitic diode when a noise signal passes through the parasitic diode is increased. Therefore, an effect of isolating the noise signal may also be improved by adding the intrinsic substrate. Therefore, the noise signal isolation effect may be further improved by further surrounding the isolation well by the intrinsic substrate.

That the isolation well is at least partially surrounded by the intrinsic substrate means that the isolation well may be partially surrounded by the intrinsic substrate or that the isolation well may be all surrounded by the intrinsic substrate. "Partial surrounding" and "all surrounding" both can implement an isolation effect, and differ in only an isolation degree.

Same parts in FIG. 3 and FIG. 2 are not described herein again.

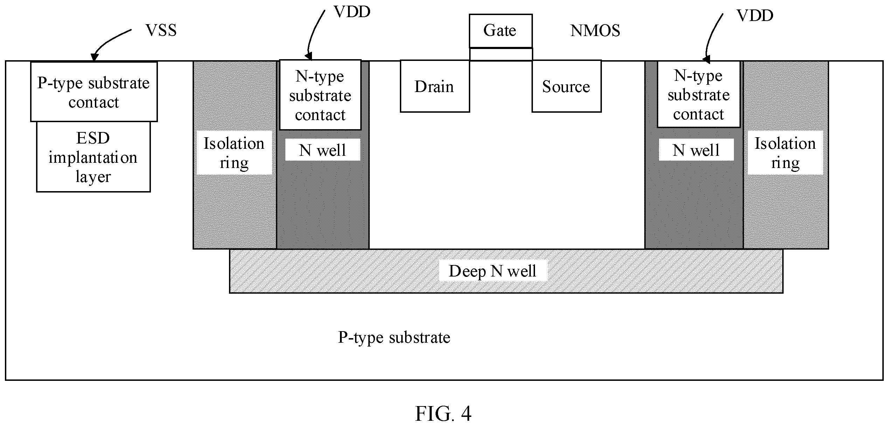

FIG. 4 is a schematic diagram of a signal isolation apparatus based on an NMOS according to this application. The signal isolation apparatus includes an NMOS device, an N-type substrate contact, a P-type substrate contact, and an isolation ring. The NMOS device includes a source, a drain, and a gate.

The NMOS device is formed on a P-type substrate and has an N well, the N-type substrate contact is formed in the N well and connected to supply voltage, and the P-type substrate contact is formed on the P-type substrate and connected to grounding voltage. The isolation ring at least partially surrounds the N well, and a density of the isolation ring is lower than a density of the N well or a density of the P-type substrate.

In the signal isolation apparatus, the N well is surrounded by the isolation ring, and the density of the isolation ring is lower than the density of the N well or the density of the P-type substrate. Therefore, a junction capacitance of a P-N junction formed between the N well node and the P-type substrate node is decreased, and an equivalent capacitive reactance of the P-N junction when a noise signal passes through the P-N junction is increased, thereby improving an effect of isolating the noise signal.

In an embodiment of this application, the isolation ring is an isolation well, and a doping density of an N-type ion implanted into the isolation well is lower than a doping density of an N-type ion implanted into the N well. Different doping densities may be formed by implanting different doses of N-type ions into the isolation well and the N well. Compared with the junction capacitance of the P-N junction formed between the N well and the P-type substrate when the isolation well is not added, a junction capacitance of a P-N junction formed between the P-type substrate and a well obtained by considering the isolation well and the N well as a whole is lower. To be specific, the junction capacitance of the P-N junction formed between the N well and the P-type substrate is decreased, and the equivalent capacitive reactance of the P-N junction when a noise signal passes through the P-N junction is increased, thereby improving an effect of isolating the noise signal.

In an optional embodiment, the isolation well may be a high-voltage well (not shown in FIG. 4).

In an embodiment of this application, the isolation ring is an intrinsic substrate, and a doping density of a P-type ion implanted into the intrinsic substrate is lower than a doping density of a P-type ion implanted into the P-type substrate. Compared with the junction capacitance of the P-N junction formed between the N well and the P-type substrate when the intrinsic substrate is not added, a junction capacitance of a P-N junction formed between the N well and a P-type substrate obtained by considering the intrinsic substrate and the P-type substrate as a whole is lower. To be specific, the junction capacitance of the P-N junction formed between the N well and the P-type substrate is decreased, and the equivalent capacitive reactance of the P-N junction when a noise signal passes through the P-N junction is increased, thereby improving an effect of isolating the noise signal.

In an embodiment of this application, a deep N well further exists between the NMOS and the P-type substrate. The N well and the deep N well are configured to isolate the NMOS from the P-type substrate, so that a noise isolation effect can be further improved.

In an embodiment of this application, as shown in FIG. 4, the signal isolation apparatus further includes an ESD implantation layer extending deep into the P-type substrate along the P-type substrate contact. The ESD implantation layer is a P-type implantation layer, and is configured to improve an electrostatic discharge capability. A P-type implantation depth of the ESD implantation layer is greater than a P-type implantation depth of the P-type substrate contact.

Because the ESD implantation layer and the P-type substrate contact both are in P-type implantation, the ESD implantation layer may extend the P-type substrate contact. In this way, the ESD implantation layer and the P-type substrate contact can have more contact with a noise signal, and absorb more noise signals to the ground, thereby improving an effect of absorbing a noise signal.

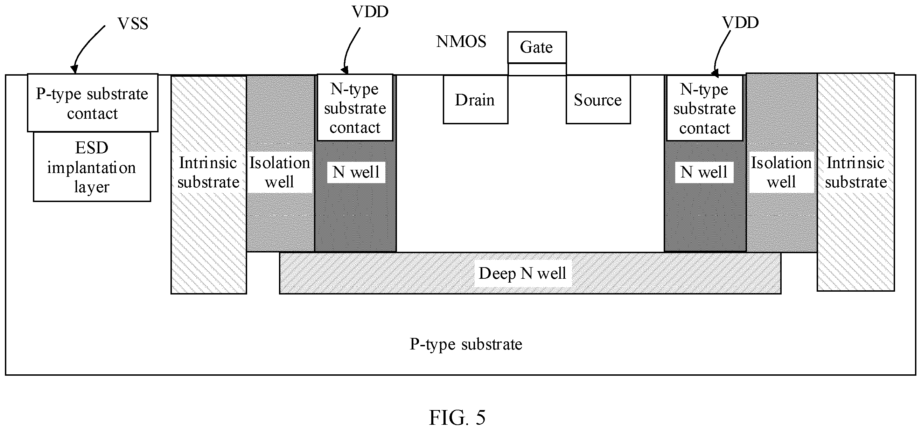

FIG. 5 is a schematic diagram of another signal isolation apparatus based on an NMOS according to this application. A difference between the signal isolation apparatus and the signal isolation apparatus shown in FIG. 4 lies in that the isolation ring is the isolation well, and on the basis that the N well is at least partially surrounded by the isolation well, the isolation well is further at least partially surrounded by the intrinsic substrate. A noise signal isolation effect may be further improved by further surrounding the isolation well by the intrinsic substrate.

Same parts in FIG. 5 and FIG. 4 are not described herein again.

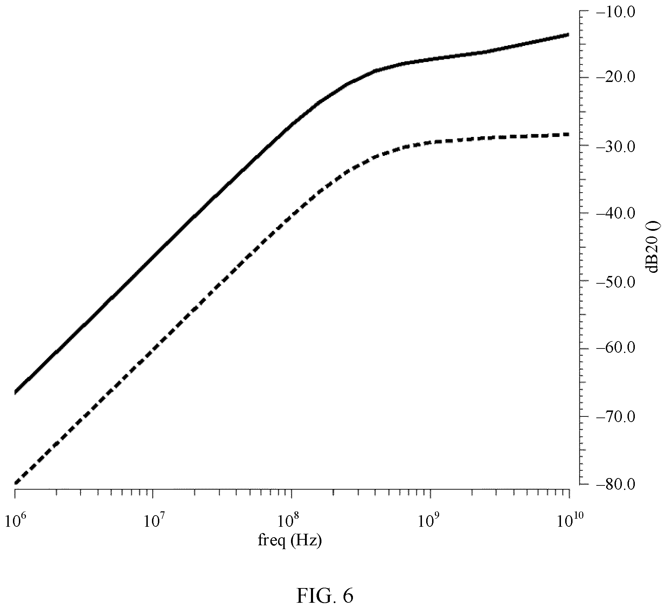

To further describe an effect generated by the signal isolation apparatus shown in FIG. 5, FIG. 6 is a simulation diagram of an isolation effect generated by the signal isolation apparatus shown in FIG. 5. It should be noted that the simulation effect in FIG. 6 does not include an effect generated by the ESD implantation layer, that is, the signal isolation apparatus to which FIG. 6 is specific does not include the ESD implantation layer. In addition, the isolation well to which simulation shown in FIG. 6 is specific is a high-voltage well.

FIG. 6 is a simulation diagram of a comparison between an isolation effect brought by surrounding the N well by a high-voltage well and an isolation effect brought by surrounding the N well by no high-voltage well. A horizontal coordinate is a frequency of a noise signal, and a vertical coordinate is an isolation degree. A solid line is a simulation curve for a case in which the N well is surrounded by no well or substrate, and a dashed line is a simulation curve formed after the N well is surrounded by a high-voltage well and the high-voltage well is surrounded by an intrinsic substrate. A width of the high-voltage well and a width of the intrinsic substrate are both 1 µm. A section from 1 MHz to 10 GHz is intercepted. It can be learned that at 1 GHz, isolation is improved by more than 12 dB after the width of the high-voltage well and the intrinsic substrate are added.

In the foregoing embodiments, the signal isolation apparatus is mainly for a single transistor device, for example, for a PMOS or an NMOS. To further describe application of a signal isolation structure in a module, inter-module application of the signal isolation apparatus is further described in the following embodiment.

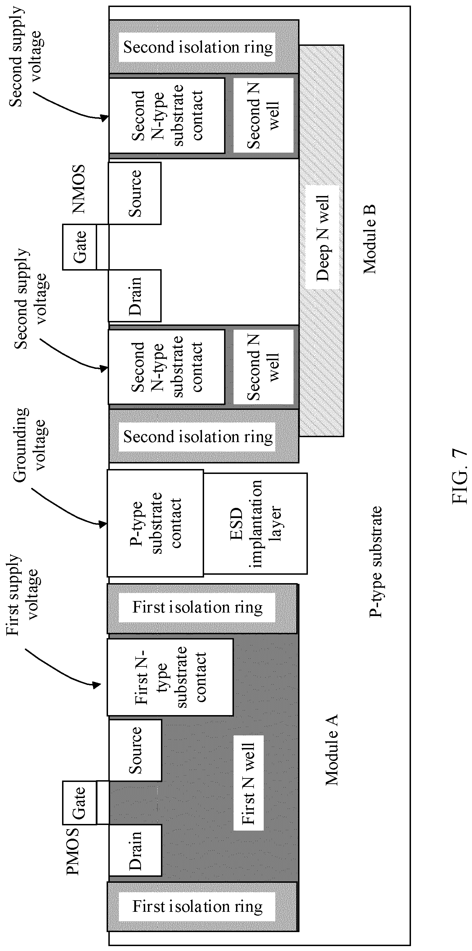

FIG. 7 is a signal isolation apparatus for inter-module application according to an embodiment of this application. The inter-module isolation structure includes two modules: a module A and a module B. The module A and the module B are formed on a P-type substrate. For example, the module A includes a PMOS, and module B includes an NMOS.

Specifically, the PMOS device is formed on the P-type substrate and has a first N well. A first N-type substrate contact is formed in the first N well and connected to first supply voltage. The NMOS device is formed on the P-type substrate and has a second N well. A second N-type substrate contact is formed in the second N well and connected to second supply voltage. The P-type substrate contact is formed on the P-type substrate and connected to grounding voltage. A first isolation ring at least partially surrounds the first N well, and a second isolation ring at least partially surrounds the second N well. A doping density of an ion implanted into the first isolation ring is lower than a doping density of an ion implanted into the first N well or a doping density of an ion implanted into the P-type substrate. A doping density of an ion implanted into the second isolation ring is lower than a doping density of an ion implanted into the second N well or the doping density of the ion implanted into the P-type substrate.

Specifically, the first isolation ring and the second isolation ring each may be an isolation well or an intrinsic substrate. The isolation well may be a high-voltage well.

Further, the signal isolation apparatus includes an ESD implantation layer extending deep into the P-type substrate along the P-type substrate contact. The ESD implantation layer is a P-type implantation layer, and is configured to improve an electrostatic discharge capability.

Further, a P-type implantation depth of the ESD implantation layer is greater than a P-type implantation depth of the P-type substrate contact.

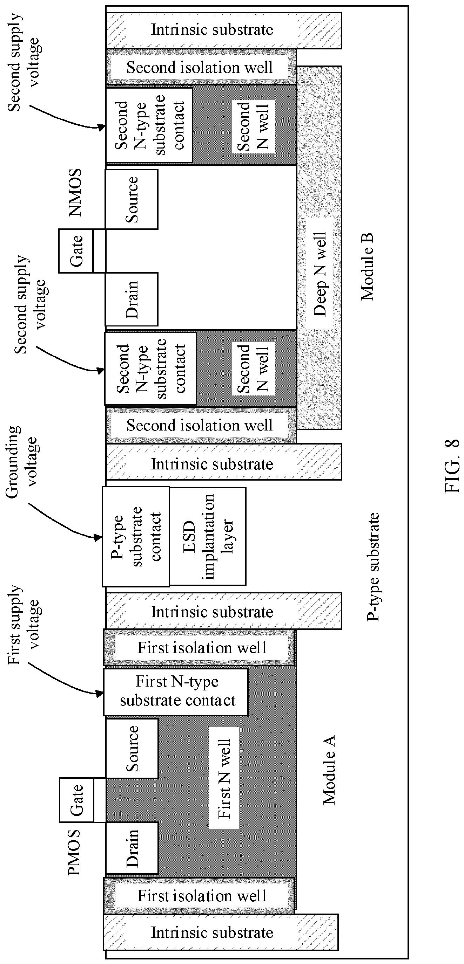

FIG. 8 is another signal isolation apparatus according to an embodiment of this application. Compared with the inter-module signal isolation apparatus shown in FIG. 7, in the inter-module signal isolation apparatus, the first isolation ring is a first isolation well, the second isolation ring is a second isolation well, and on the basis that the first N well and the second N well are surrounded by the isolation well, the isolation well is partially surrounded by an intrinsic substrate.

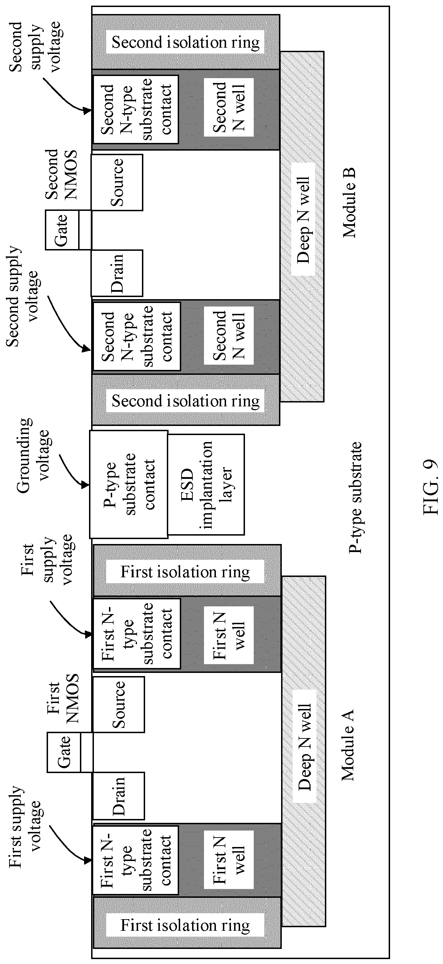

FIG. 9 is another signal isolation apparatus according to an embodiment of this application. The inter-module signal isolation apparatus includes two modules: a module A and a module B. The module A and the module B are formed on a P-type substrate. For example, the module A includes a first NMOS, and the module B includes a second NMOS.

Specifically, the first NMOS device is formed on the P-type substrate and has a first N well. A first N-type substrate contact is formed in the first N well and connected to first supply voltage. The second NMOS device is formed on the P-type substrate and has a second N well. A second N-type substrate contact is formed in the second N well and connected to second supply voltage. The P-type substrate contact is formed on the P-type substrate and connected to grounding voltage. A first isolation ring at least partially surrounds the first N well and a second isolation ring at least partially surrounds the second N well. A doping density of an ion implanted into the first isolation ring is lower than a doping density of an ion implanted into the first N well or a doping density of an ion implanted into the P-type substrate. A doping density of an ion implanted into the second isolation ring is lower than a doping density of an ion implanted into the second N well or the doping density of the ion implanted into the P-type substrate.

Specifically, the isolation ring may be an isolation well or an intrinsic substrate. The isolation well may be a high-voltage well.

Further, the signal isolation apparatus includes an ESD implantation layer extending deep into the P-type substrate along the P-type substrate contact. The ESD implantation layer is a P-type implantation layer, and is configured to improve an electrostatic discharge capability. A P-type implantation depth of the ESD implantation layer is greater than a P-type implantation depth of the P-type substrate contact.

Further, a deep N well exists between the first NMOS and the P-type substrate and between the second NMOS and the P-type substrate. Therefore, a noise isolation effect may be further improved.

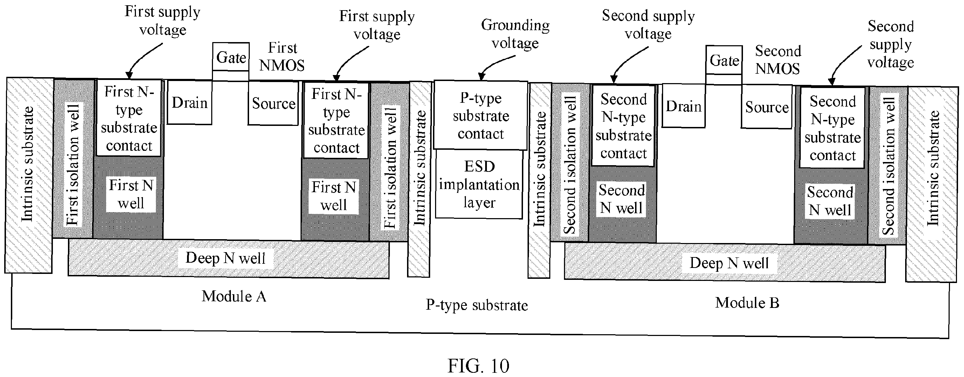

FIG. 10 is another signal isolation apparatus according to an embodiment of this application. Compared with the inter-module signal isolation apparatus shown in FIG. 9, in the inter-module signal isolation apparatus, the first isolation ring is a first isolation well, the second isolation ring is a second isolation well, and on the basis that the first N well and the second N well are surrounded by the isolation well, the isolation well is partially surrounded by an intrinsic substrate.

The two modules in FIG. 9 and FIG. 10 each include an NMOS. Similarly, the NMOS included in each of the two modules in FIG. 9 and FIG. 10 may be replaced with a PMOS. Because design principles of signal isolation apparatuses are the same, an inter-module signal isolation apparatus in which the two modules each includes a PMOS is not further described herein.

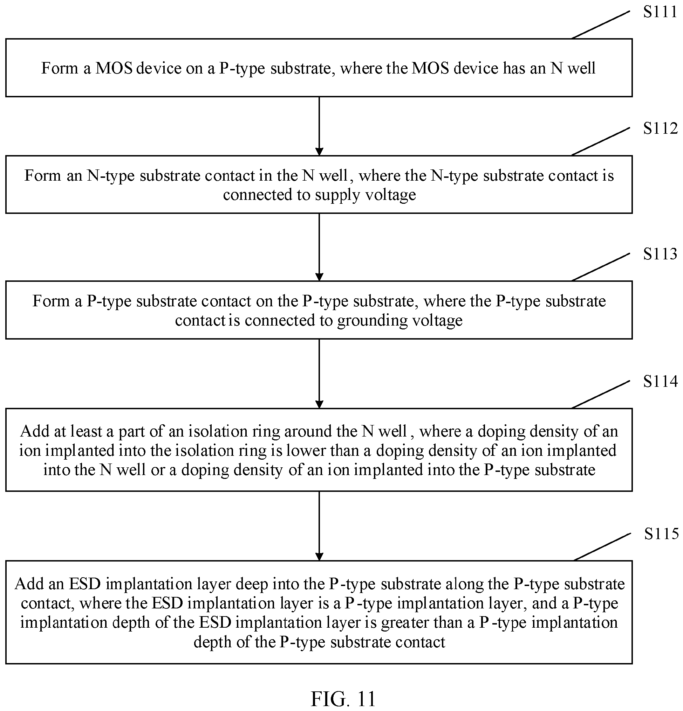

FIG. 11 is a signal isolation method according to an embodiment of this application. Specifically, the embodiment includes the following steps.

S111. Form a MOS device on a P-type substrate, where the MOS device has an N well.

S112. Form an N-type substrate contact in the N well, where the N-type substrate contact is connected to supply voltage.

S113. Form a P-type substrate contact on the P-type substrate, where the P-type substrate contact is connected to grounding voltage.

S114. Add at least a part of an isolation ring around the N well, where a doping density of an ion implanted into the isolation ring is lower than a doping density of an ion implanted into the N well or a doping density of an ion implanted into the P-type substrate.

In an embodiment of this application, the isolation ring is an isolation well, and a doping density of an N-type ion implanted into the isolation well is lower than a doping density of an N-type ion implanted into the N well. Further, the isolation well may be a high-voltage well.

Further, at least a part of an intrinsic substrate is added around the isolation well.

In an embodiment of this application, the isolation ring is an intrinsic substrate, and a doping density of a P-type ion implanted into the intrinsic substrate is lower than a doping density of a P-type ion implanted into the P-type substrate.

In an embodiment of this application, the embodiment may further include:

S115. Add an ESD implantation layer deep into the P-type substrate along the P-type substrate contact, where the ESD implantation layer is a P-type implantation layer, and a P-type implantation depth of the ESD implantation layer is greater than a P-type implantation depth of the P-type substrate contact.

Further, the MOS device may be a PMOS or an NMOS. When the MOS device is an NMOS, the signal isolation method may further include: adding a deep N well between the NMOS and the P-type substrate. The N well and the deep N well separate the NMOS from the P-type substrate.

It should be noted that a sequence of performing the steps such as S111 to S115 is not limited in this application.

The N well is surrounded by the isolation ring, and a density of the isolation ring is lower than a density of the N well or a density of the P-type substrate. Therefore, a junction capacitance of a P-N junction formed between the N well and the P-type substrate is decreased, and an equivalent capacitive reactance of the P-N junction when a noise signal passes through the P-N junction is increased, thereby improving an effect of isolating the noise signal.

The foregoing descriptions are merely specific embodiments of this application, but are not intended to limit the protection scope of this application. Any modification or replacement readily figured out by a person skilled in the art within the technical scope disclosed in this application shall fall within the protection scope of this application. Therefore, the protection scope of this application shall be subject to the protection scope of the claims.

## Claims

1. A signal isolation apparatus, comprising:
a metal oxide semiconductor (MOS) device, wherein the MOS device is formed on a P-type substrate and has an N well;
an N-type substrate contact, wherein the N-type substrate contact is formed in the N well and connected to supply voltage;
a P-type substrate contact, wherein the P-type substrate contact is formed on the P-type substrate and connected to grounding voltage; and
an isolation ring at least partially surrounding the N well, wherein a doping density of an ion implanted into the isolation ring is lower than a doping density of an ion implanted into the N well or a doping density of an ion implanted into the P-type substrate.

2. The signal isolation apparatus according to claim 1, wherein the isolation ring is an isolation well, and a doping density of an N-type ion implanted into the isolation well is lower than a doping density of an N-type ion implanted into the N well.

3. The signal isolation apparatus according to claim 2, wherein the isolation well is a high-voltage well.

4. The signal isolation apparatus according to claim 2 or 3, further comprising:
an intrinsic substrate at least partially surrounding the isolation well, wherein a doping density of a P-type ion implanted into the intrinsic substrate is lower than a doping density of a P-type ion implanted into the P-type substrate.

5. The signal isolation apparatus according to claim 1, wherein the isolation ring is an intrinsic substrate, and a doping density of a P-type ion implanted into the intrinsic substrate is lower than a doping density of a P-type ion implanted into the P-type substrate.

6. The signal isolation apparatus according to any one of claims 1 to 5, further comprising:
an electrostatic discharge (ESD) implantation layer extending deep into the P-type substrate along the P-type substrate contact, wherein the ESD implantation layer is a P-type implantation layer.

7. The signal isolation apparatus according to any one of claims 1 to 6, wherein the MOS device is a PMOS.

8. The signal isolation apparatus according to any one of claims 1 to 6, wherein the MOS device is an NMOS.

9. The signal isolation apparatus according to claim 8, wherein a deep N well exists between the NMOS and the P-type substrate, and the N well and the deep N well separate the NMOS from the P-type substrate.

10. A signal isolation method, comprising:
forming a metal oxide semiconductor (MOS) device on a P-type substrate, wherein the MOS device has an N well;
forming an N-type substrate contact in the N well, wherein the N-type substrate contact is connected to supply voltage;
forming a P-type substrate contact on the P-type substrate, wherein the P-type substrate contact is connected to grounding voltage; and
adding at least a part of an isolation ring around the N well, wherein a doping density of an ion implanted into the isolation ring is lower than a doping density of an ion implanted into the N well or a doping density of an ion implanted into the P-type substrate.

11. The signal isolation method according to claim 10, wherein the isolation ring is an isolation well, and a doping density of an N-type ion implanted into the isolation well is lower than a doping density of an N-type ion implanted into the N well.

12. The signal isolation method according to claim 11, wherein the isolation well is a high-voltage well.

13. The signal isolation method according to claim 10 or 11, further comprising:
adding at least a part of an intrinsic substrate around the isolation well, wherein a doping density of a P-type ion implanted into the intrinsic substrate is lower than a doping density of a P-type ion implanted into the P-type substrate.

14. The signal isolation method according to claim 10, wherein the isolation ring is an intrinsic substrate, and a doping density of a P-type ion implanted into the intrinsic substrate is lower than a doping density of a P-type ion implanted into the P-type substrate.

15. The signal isolation method according to any one of claims 10 to 14, further comprising:
adding an electrostatic discharge (ESD) implantation layer deep into the P-type substrate along the P-type substrate contact, wherein the ESD implantation layer is a P-type implantation layer.

16. The signal isolation method according to any one of claims 10 to 15, wherein the MOS device is a PMOS.

17. The signal isolation method according to any one of claims 10 to 15, wherein the MOS device is an NMOS.

18. The signal isolation method according to claim 17, wherein a deep N well exists between the NMOS and the P-type substrate, and the N well and the deep N well separate the NMOS from the P-type substrate.
